# EUROPEAN PATENT APPLICATION

(11) **EP 3 748 802 A1**
(43) Date of publication of application: **09.12.2020**
(21) Application number: 20166983.5
(22) Date of filing: 31.03.2020
(51) Int. Cl.: H02J 7/00

(54) **CHARGER WITH IMPROVED HEAT RADIATION**

(30) Priority: 03.06.2019 KR 20190065181
(71) Applicant: SOLUM CO., LTD., Yongin-si, Gyeonggi-do 16914 (KR)
(72) Inventor: KIM, HyunSu, 18477 Gyeonggi-do, (KR); LEE, JunKyu, 16899 Gyeonggi-do, (KR)
(74) Representative: MacDougall, Alan John Shaw

(57) **Abstract**

Disclosed is a charger with improved heat radiation. The disclosed charger may include a case formed with an opening on one side and a terminal engaged to other side, a printed circuit board inserted to an inner side of the case and mounted with circuit elements, a heat radiation member disposed to cover the printed circuit board within the case, and comprising a metal shield, and a cover closing the opening of the case, and the heat radiation member is spaced apart from the case.

## Description

### BACKGROUND

### 1. Field

The disclosure relates to a charger for a mobile device and more specifically to a charger with improved heat radiation capable of present surface temperature from rising excessively.

### 2. Description of Related Art

The advancement in specification of mobile devices recently has led to a rise in power consumption and enabled batteries, which are power sources, to have a greater capacitance. The output of a charger for charging a battery according to the increase in greater battery capacitance is also continuously increasing. Specifically, premium model chargers around 60 Watt are being released in the market, and continuous development thereof is in progress.

Due to characteristics of a mobile device, there is an increasing need for a charger capable of high output that is compact in size.

However, the higher the output of the charger, heat generated within the charger increases, and the surface temperature of the external case of the charger rises as a result thereof. Accordingly, if a user touches the charger while charging a mobile device for a long period of time, the surface temperature of the charger case would be high resulting in problems such as causing discomfort or even low-temperature burns.

Due to issues in heat radiation within the charger, when producing a compact charger, there is difficulty in effectively dispersing heat generated inside the charger.

### SUMMARY

An object of the disclosure is to provide a charger capable of resolving problems such as a user experiencing low-temperature burn by forming the size of the charger to be compact and slim while evenly distributing heat radiation within the charger to the outside of the charger.

According to an embodiment of the disclosure, a charger including a case formed with an opening on one side and a terminal engaged to other side; a printed circuit board inserted to an inner side of the case and mounted with circuit elements; a heat radiation member disposed to cover the printed circuit board within the case, and comprising a metal shield; and a cover closing the opening of the case may be provided, in which the heat radiation member is spaced apart from the case.

The heat radiation member may further include an insulator, and the metal shield may encase an outer surface of the insulator adjacent to the case.

The insulator may be formed with a pair of slots for both ends of the printed circuit board to be slidingly engagable in an inner side surface thereof.

The insulator may be configured in a container shape to surround the printed circuit board, and the metal shield may encase the outer surface of the insulator.

The insulator may include a first step and a second step protruding in a vertical direction from both ends of an outer side surface exposed from the metal shield, and the first step and the second step may be in contact with the case.

The metal shield may be bonded and engaged to the outer surface of the insulator.

The charger may further include an air layer provided between the heat radiation member and the case.

The heat radiation member may be disposed to be vertically overlapping the circuit elements.

The heat radiation member may include an upper part; and a lower part horizontally extending from the upper part, and a width of the upper part may be smaller than a width of the lower part.

The charger may further include an extension portion between the terminal and the case, and the extension portion may have a step from the case.

The cover may include a terminal insertion hole for passing therethrough.

According to an embodiment of the disclosure, a charger including a case provided with an inner space; a printed circuit board disposed within the case and mounted with circuit elements; a heat radiation member disposed between the circuit elements and the case within the case; a terminal engaged to one side of the case; and an air layer provided between the heat radiation member and the case may be provided.

The heat radiation member may include an insulator; and a metal shield covering an outer surface of the insulator adjacent to the case.

The metal shield may have a thickness smaller than a thickness of the insulator

The insulator may extend along an inner surface of the case and surround the printed circuit board, and the metal shield may surround the outer surface of the insulator

The metal shield and the insulator may be integrated.

The insulator may include a first step and a second step protruding from both ends of the outer side surface exposed from the metal shield, and the first step and the second step may be in contact with the case.

The insulator may be formed with a pair of slots for both ends of the printed circuit board to be slidingly engagable in an inner side surface thereof.

The charger may further include a cover disposed to an other side opposite to the one side of the case, and the cover may include a terminal injection hole passing therethrough.

The heat radiation member may include an upper part; and a lower part horizontally extending from the upper part, and a side surface of the upper part may be misaligned with a side surface of the lower part.

According to an embodiment as described above, the heat generated from the circuit elements disposed in the interior may not be concentrated at a specific part but is evenly dispersed to the entire case through the heat radiation unit, and may then be radiated to the outside. Accordingly, the surface temperature of the charger may be lowered to prevent the user from experiencing discomfort or low-temperature burn due to high temperature when handling the charger, and the heat generated from the circuit elements inside the charger may be effectively radiated to prevent deterioration of the circuit elements

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a perspective view illustrating a charger according to an embodiment of the disclosure;
FIG. 2 is an exploded perspective view illustrating a case and a heat radiation unit of a charger according to an embodiment of the disclosure;
FIG. 3 is a perspective view illustrating a heat radiation unit engaged to an inner side of a case of a charger according to an embodiment of the disclosure;
FIG. 4 is a cross-sectional view taken along line IV-IV shown in FIG. 1;
FIG. 5 is a schematic sectional view illustrating an example of an air layer being formed between an inner side surface of a case and an outer side surface of a heat-absorbing member;
FIG. 6 is an exploded perspective view illustrating a case and a heat radiation unit of a charger according to another embodiment of the disclosure; and
FIG. 7 is an enlarged view of a VII part shown in FIG. 6 seen from an A direction.

### DETAILED DESCRIPTION

Various embodiments of the disclosure will be explained in greater detail below with reference to the attached drawings. The embodiments disclosed herein may be variously modified. Specific embodiments may be illustrated in the drawings and described in detail in the detailed description. However, the specific embodiments disclosed in the attached drawings are merely provided for the better understanding of the various embodiments. Accordingly, the technical idea is not limited to the specific embodiments disclosed in the attached drawings, and it should be understood as including all equivalents or alternatives included in the technical idea and scope thereof.

Terms including ordinals such as "first," "second," and so on may be used to describe various elements, but the elements should not be limited by the above-described terms. The above-described terms may be used only for the purpose of distinguishing one element from another.

Terms such as "comprise", "consist of', or the like are used herein to designate a presence of a characteristic, number, step, operation, element, component, or a combination thereof, and not to preclude a presence or a possibility of adding one or more of other characteristics, numbers, steps, operations, elements, components or a combination thereof. If one element is disclosed as being "coupled with/to" or "connected to" another element, it should be interpreted as being directly coupled with or connected to the another element or other element may be present therebetween. On the other hand, when one element is disclosed as being "directly coupled with" or "directly connected to" another element, it should be interpreted as no other element being present therebetween.

In addition, in describing embodiments, based on determining that detailed description of functions or configurations of related known art may unnecessarily confuse the gist of the disclosure, a detailed description thereof may be omitted.

A structure of a charger according to an embodiment of the disclosure will be described below with reference to the drawings.

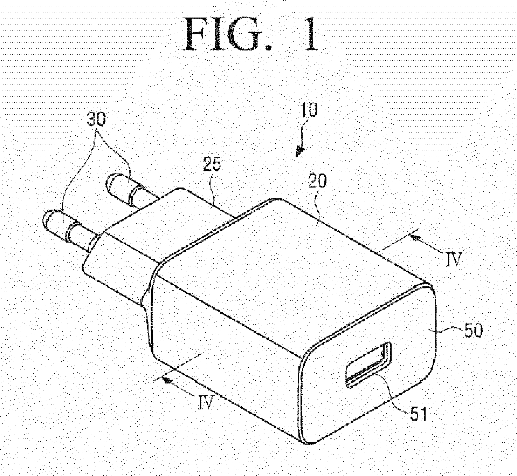

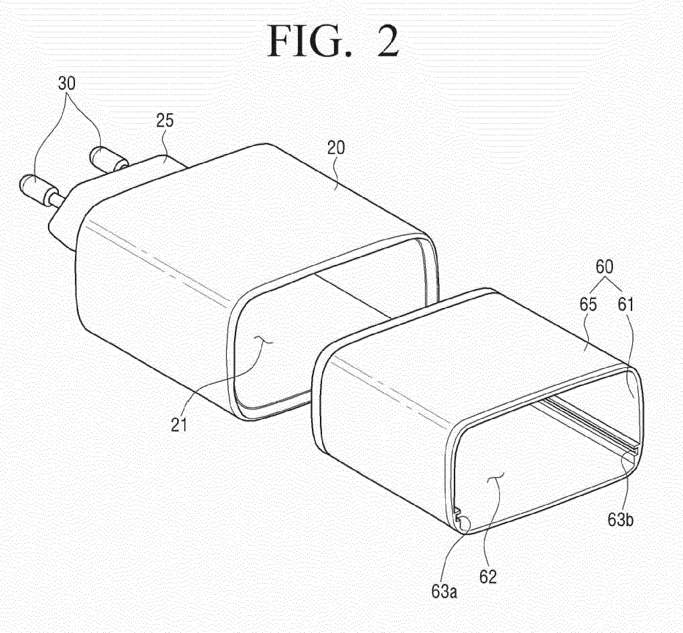

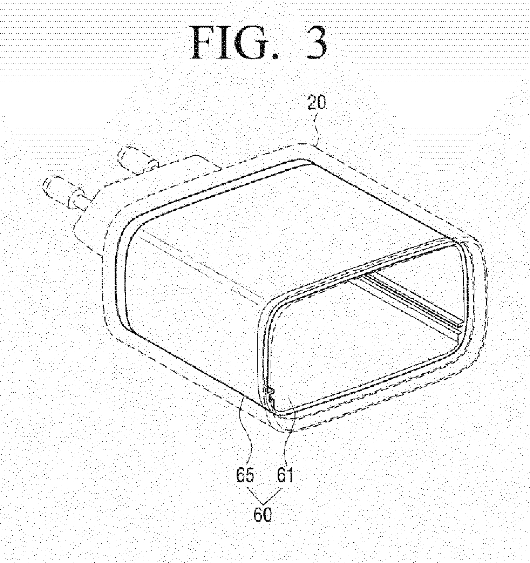

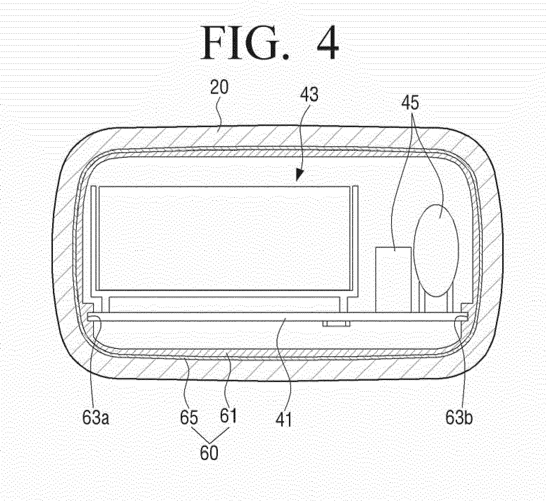

FIG. 1 is a perspective view illustrating a charger according to an embodiment of the disclosure, FIG. 2 is an exploded perspective view illustrating a case and a heat radiation unit of a charger according to an embodiment of the disclosure, FIG. 3 is a perspective view illustrating a heat radiation unit engaged to an inner side of a case of a charger according to an embodiment of the disclosure, and FIG. 4 is a cross-sectional view taken along line IV-IV as shown in FIG. 1.

Referring to FIGS. 1 to 4, a charger with improved heat radiation includes a charger 10, a case 20, a terminal 30, a printed circuit board 41, a cover 50, and a heat radiation member 60.

The case 20 may be formed with an opening 21 on a one side of the case for inserting the printed circuit board 41 and the heat radiation member 60. The case 20 may have a form corresponding to the form of the heat radiation member 60. That is, the case 20 may be variously modified according to the form of the heat radiation member 60. As illustrated in FIG. 2, a cross section may be produced as an approximate rectangular container shape. The case 20 may be produced by plastic injection molding.

The case 20 may be formed with an opening for inserting the printed circuit board 41, which is mounted with a transformer 43 and circuit elements 45 on the one side, and the heat radiation member to the interior of the case.

The case 20 may be formed with an extension portion 25 on the other side thereof. The extension portion 25 may be formed smaller than the case 20 to be insertable into the socket (not shown) of the case 20. The extension portion 25 may be integrally formed to be stepped from the case 20. The extension portion 25 may be separately produced from the case 20 and engaged to the other side of the case 20 by bonding or a snap fit joining structure.

The terminal 30 may be engaged to the one side of the case 20, and based on the terminal 30 being inserted into the socket, power may be provided to the charger 10. The terminal 30 may be engaged to the tip end of the extension portion 25.

A plurality of terminals 30 may be disposed to be spaced apart from each other. The number and size of the terminals 30 may be variously modified.

The shape of a step 25, the shape of the terminal 30, and arrangement thereof described by the detailed description may be variously implemented, and may be appropriately modified according to the specific specifications regulated by each country.

The printed circuit board 41 may be provided with a transformer 43, circuit elements 45, and a socket (not shown) to which a terminal of an external cable is electrically connected. The external cable may be configured to electrically couple the mobile device and the charger. Accordingly, the type of terminal may be at least one of a USB terminal, a micro 5-pin terminal, or a lightning 8-pin terminal and the socket may be formed in a structure corresponding to the type of a cable terminal.

The printed circuit board 41 may provide voltage and current appropriate to the mobile device (not shown) to be used by converting high voltage electricity.

The cover 50 may be engaged so as to be separable from the opening of the case 20, and may close the opened one surface of the case 120. A terminal insertion hole 51 through which an external cable terminal is engaged to the socket of the printed circuit board 41 may be formed.

The cover 50 may be produced by plastic injection molding as with the case 20. Although not illustrated in the drawings, a heat radiation plate formed with metal materials may be disposed in the inner side surface of the cover 50. The heat generated from the circuit elements disposed in the interior of the case 20 may be dispersed to the cover 50 through the heat radiation plate while at the same time radiated to the outside.

The heat radiation member 60 may be implemented in a container shape having a hollow part 62 formed with openings on each side of both ends as shown in FIG. 2. The interior of the heat radiation member 60 may be disposed with the printed circuit board 41 mounted with the transformer 43 and the circuit elements 45 as shown in FIG. 4.

The heat radiation member 60 may be implemented in a shape surrounding the printed circuit board 41 to absorb the heat generated from the heat generating components when in operation from the electronic components mounted in the printed circuit board 41, thus minimizing electronic components from degrading due to heat radiation.

The heat radiation member 60 may include an insulator 61 and a metal shield 65 that encases the insulator 61. The heat radiation member 60 may cover the outer surface of the insulator 61 adjacent to the case 20.

The insulator 61 may prevent the electronic components or circuit wires of the printed circuit board 41 from short-circuiting with the metal shield 65.

The insulator 61 may be formed through insert injection molding together with the metal shield 65. Accordingly, the insulator 61and the metal shield 65 of different materials may be integrally formed.

The heat radiation member 60 may be formed more compactly by forming the metal shield 65 for heat absorption thinner than a thickness of insulator 61 consisting of insulating synthetic resin. Accordingly, the charger 10 according to an embodiment of the disclosure may, based on inserting the compact heat radiation member 60 to the inner side thereof, improve convenience in portability by forming the overall size of the charger to be minimal and slim.

Further, based on producing two components of the insulator 61and the metal shield 65 as the heat radiation member 60, a single component, through insert injection molding, production may be improved by reducing assembly process.

The insulator 61 may be formed with a pair of guide slots 63a and 63b so that each of both ends of the printed circuit board 41 are inserted to be slidable along both side surfaces of the inner side thereof.

The metal shield 65 may be formed with metal materials with superior thermal conductivity (for example, aluminum, copper, etc.), and may be integrally formed with the insulator 61 by press molding a metal plate to produce a container shape and thereafter through insert injection molding.

The metal shield 65 may have a shape corresponding to the shape of the insulator 61. That is, the metal shield 65 may be variously modified according to the shape of the insulator 61.

The metal shield 65 encases the outer surface of the insulator 61 and absorbs heat generated from the circuit elements of the printed circuit board 41.

The heat generated from the circuit elements of the printed circuit board 41 may first be absorbed by the insulator 61, and then absorbed to the metal shield 65 in close contact with the outer side surface thereof. The inner side surface of the insulator 61 mounted with circuit elements of the printed circuit board 41 may show a thermal concentration effect.

The metal shield 65 disperses the heat concentrated at a portion of the insulator to the entire area of the metal shield 65. Accordingly, the heat generated from the interior of the charger 10 is evenly dispersed to the front surface, the back surface, the left side surface and the right side surface of the case 20 and then radiated into air.

The charger 10 provided with the heat radiation member 60 formed to encase the printed circuit board 41 may maintain the compact size while absorbing the heat generated from the interior when the charger is operated to evenly disperse and radiate heat throughout the charger.

Accordingly, the heat may be prevented from being concentrated at a specific portion and even if a user comes into contact with the charger or the like, the user may be fundamentally prevented from experiencing discomfort or low-temperature burn due to the heat generated inside the charger.

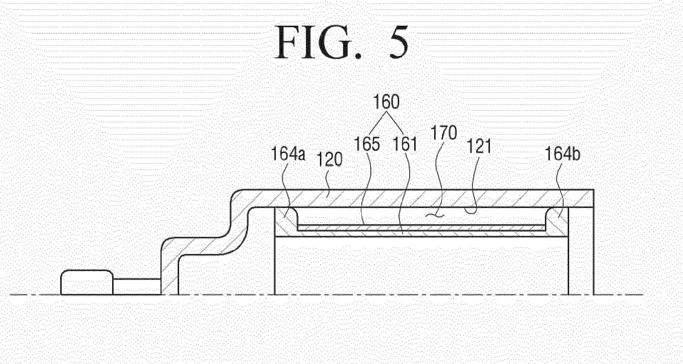

The aforementioned heat radiation member 60 may be configured so that the metal shield 65 is in contact with the inner side surface of the case 20 or is spaced apart at very small intervals. However, the heat radiation member 60 is not limited to the configuration described above and may also be configured to secure a constant air layer between the inner side of the case 20 and the metal shield 65. The specific structure thereof will be described in detail with reference to FIG. 5.

FIG. 5 is a schematic sectional view illustrating an example of an air layer being formed between an inner side surface of a case and an outer side surface of a heat-absorbing member.

Referring to FIG. 5, the insulator 161 forming a part of the heat radiation member 160 may be formed with a first step and a second step 164a and 164 of a fixed height according to the outer side surface of both ends.

The first step and the second step 164a and 164b may, based on the heat radiation member 160 being inserted into inner side of the case 120, be in close contact with the inner side surface of the case 120. The first step and the second step 164a and 164b may relatively protrude by reducing the thickness between both ends of the insulator excluding the both ends of the above-described insulator 61. That is, the thickness of the first step and the second step 164a and 164b of both ends of the insulator 61 illustrated in FIG. 5 may be formed identically with the thickness of both ends of the insulator 61 illustrated in FIG. 2.

Even in the case of using the heat radiation member 160 provided with the insulator 161, the case may be slimly formed without increasing the thickness of the case.

The metal shield 165 that forms the heat radiation member 160 together with the insulator 161 may, based on the outer side surface being separated from the inner side surface of the case 120 by a predetermined distance, be provided with an air layer 170 of a predetermined thickness between the inner side surface of the case 120 and the outer side surface of the metal shield 165.

Accordingly, the air layer 170 between the case 120 and the metal shield 165 may function as an insulating layer. That is, the air layer 170 may ease the speed at which the heat absorbed to the metal shield 165 is transferred to the case 120, thus lowering the surface temperature of the case 120.

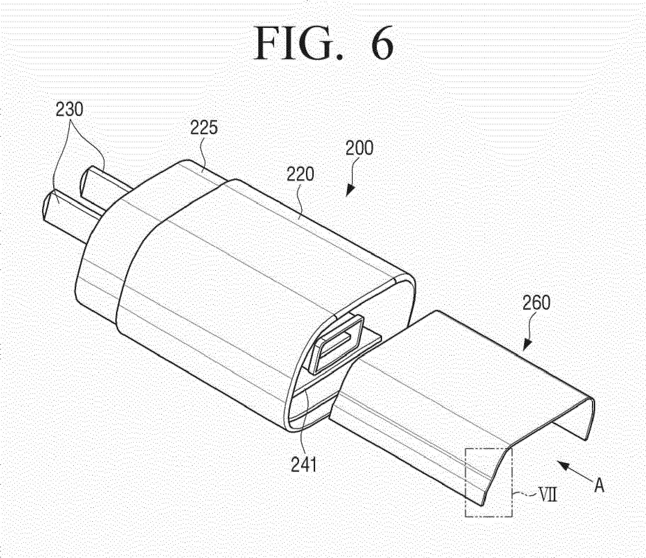

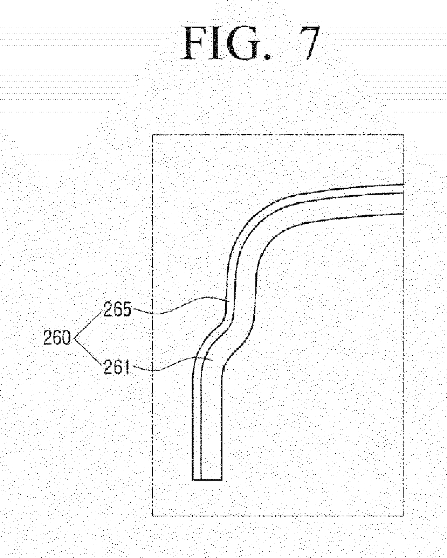

The above described heat radiation members 60 and 160 are formed in a container shape to entirely encase the printed circuit board 41, but are not limited thereto, and may be formed in the shape that encases only a part of the printed circuit board 41. The above-described structure will be described in detail with reference to FIGS. 6 and 7.

FIG. 6 is an exploded perspective view illustrating a case and a heat radiation unit of a charger according to another embodiment of the disclosure in which the illustration of the cover engaged to the opening of the case is omitted, and FIG. 7 is an enlarged view of a VII part shown in FIG. 6 seen from an A direction.

Referring to FIGS. 6 and 7, the charger 200 according to another embodiment may include a case 220, a terminal 230, a printed circuit board 241, a cover (not shown), and a heat radiation member 260.

The printed circuit board 241 may be disposed at the inner side of the case 220. The printed circuit board 241 may be fixed to the inner side of the case through a fixing piece (not shown) or both ends may be slidingly engaged to a pair of sliding slots (not shown) in the inner side of the case 220. In addition, the case 220 may form an extension portion 225 to which the terminal 230 is engaged to an opposite side of the opening.

The charger 200 according to another embodiment of the disclosure may be formed so that the heat radiation member 260 does not entirely encase the printed circuit board 241 and only encase a part of the printed circuit board 241. The part encased by the heat radiation member 260 may be the part mounted with the circuit elements, which are the heat radiating part in the printed circuit board 241.

Referring to FIG. 7, the heat radiation member 260 may include an insulator 261 and a metal shield 265 engaged to the outer side surface of the insulator 261. The heat radiation member 260 may be formed so that the width of an upper part is smaller than the width of the lower part.

The insulator 261 may be produced by plastic injection molding, and both wings may be formed extending from both sides of the upper part. The shape of the insulator 261 was formed to consider encasing the circuit elements of the printed circuit board 241. That is, the insulator 261 may encase the upper part and the side part of the circuit elements of the printed circuit board 241.

The metal shield 265 may be formed with metal materials having superior thermal conductively as the above-described metal shield 65.

The metal shield 265 may be bonded and engaged to the outer side surface of the insulator 261. However, the engagement between the insulator 261 and the metal shield 265 may be made through insert injection.

The metal shield 265 may be formed in the same or similar shape with the shape of the insulator 261. In addition, the metal shield 265 may, based on circumstance, be formed to cover the entire outer side surface of the insulator 261 or a part of the outer side surface.

According to the above-described embodiments of the disclosure, the heat generated from the circuit elements of the printed circuit board disposed in the interior of the charger may not be concentrated at a specific part but is evenly dispersed to the entire case through the heat radiation unit, and may be radiated to the outside.

Accordingly, the embodiments of the disclosure disclose of lowering the surface temperature of the charger to prevent the user from experiencing discomfort or low-temperature burn due to high temperature when handling the charger. Further, the heat generated from the circuit elements inside the charger may be effectively radiated to prevent deterioration of the circuit elements.

While the disclosure has been illustrated and described with reference to various exemplary embodiments thereof, the present disclosure is not limited to the specific embodiments described. It will be understood by those skilled in the art that various changes in form and details may be made therein without departing from the spirit and scope of the disclosure, and the various changes in form and details are not to be understood as individual from the technical idea or the scope of the disclosure.

## Claims

1. A charger comprising:
a case formed with an opening on one side and a terminal engaged to other side;
a printed circuit board inserted to an inner side of the case and mounted with circuit elements;
a heat radiation member disposed to cover the printed circuit board within the case, and comprising a metal shield; and
a cover closing the opening of the case,
wherein the heat radiation member is spaced apart from the case.

2. The charger as claimed in claim 1, wherein the heat radiation member further comprises an insulator, and the metal shield encases an outer surface of the insulator adjacent to the case.

3. The charger as claimed in claim 2, wherein the insulator is formed with a pair of slots for both ends of the printed circuit board to be slidingly engagable in an inner side surface thereof.

4. The charger as claimed in claim 2, wherein the insulator is configured in a container shape to surround the printed circuit board, and the metal shield encases the outer surface of the insulator.

5. The charger as claimed in claim 2, wherein the insulator comprises a first step and a second step protruding in a vertical direction from both ends of an outer side surface exposed from the metal shield, and
wherein the first step and the second step is in contact with the case.

6. The charger as claimed in claim 2, wherein the metal shield is bonded and engaged to the outer surface of the insulator.

7. The charger as claimed in claim 1, further comprising an air layer provided between the heat radiation member and the case.

8. The charger as claimed in claim 1, wherein the heat radiation member is disposed to be vertically overlapping the circuit elements.

9. The charger as claimed in claim 1, wherein the heat radiation member comprises:
an upper part; and
a lower part horizontally extending from the upper part,
wherein a width of the upper part is smaller than a width of the lower part.

10. The charger as claimed in claim 1, further comprising:
an extension portion between the terminal and the case, and
wherein the extension portion has a step from the case.

11. The charger as claimed in claim 1, wherein the cover comprises a terminal insertion hole for passing therethrough.

12. A charger comprising:
a case provided with an inner space;
a printed circuit board disposed within the case and mounted with circuit elements;
a heat radiation member disposed between the circuit elements and the case within the case;
a terminal engaged to one side of the case; and
an air layer provided between the heat radiation member and the case.

13. The charger as claimed in claim 12, wherein the heat radiation member comprises:
an insulator; and
a metal shield covering an outer surface of the insulator adjacent to the case.

14. The charger as claimed in claim 13, wherein the metal shield has a thickness smaller than a thickness of the insulator.

15. The charger as claimed in claim 13, wherein the insulator extends along an inner surface of the case and surrounds the printed circuit board, and
wherein the metal shield surrounds the outer surface of the insulator.
